## Europäisches Patentamt
## European Patent Office
## Office européen des brevets

(11) Publication number: **0 054 471**
**B1**

(12)

# EUROPEAN PATENT SPECIFICATION

(45) Date of publication of patent specification: **22.02.89**

(21) Application number: **81401930.3**

(22) Date of filing: **04.12.81**

(51) Int. Cl.⁴: **H 01 L 29/86,** H 01 L 27/06, H 01 L 29/78 // G11C11/40

(54) Semiconductor resistor element.

(30) Priority: **12.12.80 JP 175358/80**

(43) Date of publication of application: **23.06.82 Bulletin 82/25**

(45) Publication of the grant of the patent: **22.02.89 Bulletin 89/08**

(84) Designated Contracting States: **DE FR GB NL**

(56) References cited:
EP-A-0 000 863
DE-A-2 232 274
GB-A-1 391 959
US-A-4 139 785
US-A-4 164 668

PATENTS ABSTRACTS OF JAPAN, vol. 4, no. 87, 21st June 1980, page 569 E 16, Tokyo (JP);

(73) Proprietor: **FUJITSU LIMITED**
**1015, Kamikodanaka Nakahara-ku Kawasaki-shi Kanagawa 211 (JP)**

(72) Inventor: **Aoyama, Keizo 1-11-28, Tsukimino Yamato-shi Kanagawa 242 (JP)**

Inventor: **Yamauchi, Takahiko 49, Kitaya-cho Nakahara-ku Kawasaki-shi Kanagawa 211 (JP)**

(74) Representative: **Descourtieux, Philippe et al CABINET BEAU de LOMENIE 55 rue d'Amsterdam F-75008 Paris (FR)**

Courier Press, Leamington Spa, England.

## Description

The present invention relates to a semiconductor device including a semiconductor resistor element that can be suitably used as a load resistor for static memory cells.

Static random access memories necessitate load resistors for supplying electric charge to assure static property. The load resistors constitute a memory cell together with a flip-flop circuit formed by a pair of transistors and in the flip-flop circuit one of the transistors is usually conductive and the other one is nonconductive. The load resistors supply a current to render the transistors conductive or nonconductive, and also work to maintain the transistors conductive. To minimize the power consumption of memories, however, the resistors should have a high resistance.

In recent years, there have been proposed memory cells which feature a reduced power requirement. For example, a power-supply current which had so far been required on the order of 50 to 100 mA has now been reduced to 10 to 20 mA when the memory is in the stand-by mode. With the memory of this type, the flow of current is limited when the peripheral circuits are under the stand-by condition in order to reduce the consumption of electric power. However, it is also important to reduce the consumption of electric power by the memory cells. The effort to reduce the consumption of power by the peripheral circuits becomes meaningless if heavy current flows through the memory cells. In particular, the number of memory cells increases with the increase in the memory capacity, while the peripheral circuits are not so increased. It is, therefore, important to construct memory cells which consume less electric power.

From the viewpoint of reducing the consumption of electric power and increasing the degree of integration, in recent years, a high-resistance polycrystalline silicon film has more often been as the load. This is disclosed, for example, in U.S. Patent Specification No. 4,110,776. This silicon film exhibits a greatly varying resistance depending upon the concentration of impurities; a high resistance can be easily obtained if the concentration of impurities is decreased. The concentration of impurities can be easily and accurately adjusted by ion implantation. However, the resistance of a polycrystalline silicon resistor has a very great temperature gradient. At an ordinary temperature, for example, the electric current per cell will be from 1 to 100 nA. At high temperatures, however, the current increases by about ten times, i.e., a current of 10 to 1000 nA flows. This presents a serious problem when the memory has a large capacity. If it is attempted to increase the load resistance such that the consumption of electric power remains sufficiently small even at high temperatures, the operation becomes defective at an ordinary temperature. For instance, the operation of the flip-flop circuit becomes slow, and it becomes difficult to sufficiently supply a leakage current across the source and drain of the transistor. Accordingly, the potential at the node changes, and it becomes impossible to maintain the transistors conductive or nonconductive.

In JP—A—55—53452, a semiconductor resistor element according to the precharacterizing portion of claim 1 is disclosed which is formed by a polysilicon layer coated with a metallic film via an insulating layer to enable a change of resistance value of the polysilicon resistance element to be controlled efficiently. No specific means are disclosed to compensate for reversible variations of the resistance value of the polysilicon layer with temperature during use of the device.

It is then the object of the invention to provide a semiconductor device having a resistor element formed by a semiconductor film with means for compensating the variation of the resistance of the semiconductor film with temperature during use of the semiconductor device.

According to the invention, the above object is attained by providing a semiconductor device including:

— a semiconductor resistor element in a circuit connected between a high potential level terminal and a low potential level terminal, which resistor element comprises a semiconductor film formed in a desired shape on a substrate, wirings formed at both ends of the semiconductor film and an electrode provided on the semiconductor film between said two ends via an insulating film, and

— temperature detection means which comprises a plurality of MOS transistors, the respective drains and gates of which are short-circuited, each transistor having nearly the same mutual conductance and a threshold voltage varying with temperature and being serially connected between said high potential level terminal being positive and an output terminal of the temperature detecting means, and a further short-circuited MOS transistor connected between said output terminal and ground and having a small mutual conductance so as to generate on said output terminal an output voltage varying in accordance with the temperature; and

— an output stage comprising two MOS transistors ($Q_m$, $Q_n$) connected in series between said high potential level terminal and a negative potential level terminal, the first transistor serving as a resistor with its drain and gate being short-circuited and the second transistor receiving the output voltage of the temperature detecting means through the gate thereof and having a conductivity which varies in accordance with said output voltage to cause said output stage to generate a control voltage at the connection point of both transistors, said control voltage varying between the voltage at said negative and high potential level terminals as a function of the output voltage of the temperature detecting means;

— said control voltage being applied to said electrode of the semiconductor resistor element to compensate for variations of the resistance of the semiconductor film with temperature.

A control voltage generating circuit for controlling load elements in memory cells of a semiconductor memory device is already known from DE—A—2 232 274. The load elements are in the form of FETs controlled by the control voltage. In order to compensate for variations in the threshold voltages of transistors of the memory cells, the control voltage is generated by a circuit including serially connected transistors which simulate the transistors of the memory cells.

The invention will be more readily understood from the reading of the following description made with reference to the accompanying drawings wherein:

Fig. 1 is a circuit diagram of a static memory cell;

Fig. 2 is a graph showing the change in resistance of a polycrystalline silicon semiconductor resistor relative to the change in temperature, which is used for the static memory cell of Fig. 1;

Figs. 3A and 3B are a schematic section view and a plan view, respectively, of a semiconductor resistor element according to an embodiment of the present invention;

Fig. 4 illustrates a circuit for generating a control voltage that will be applied to the semiconductor element;

Fig. 5 is a diagram illustrating the operation of the control voltage generator circuit of Figure 4; and

Fig. 6 is a plan view of a memory cell employing the semiconductor resistor element according to the present invention.

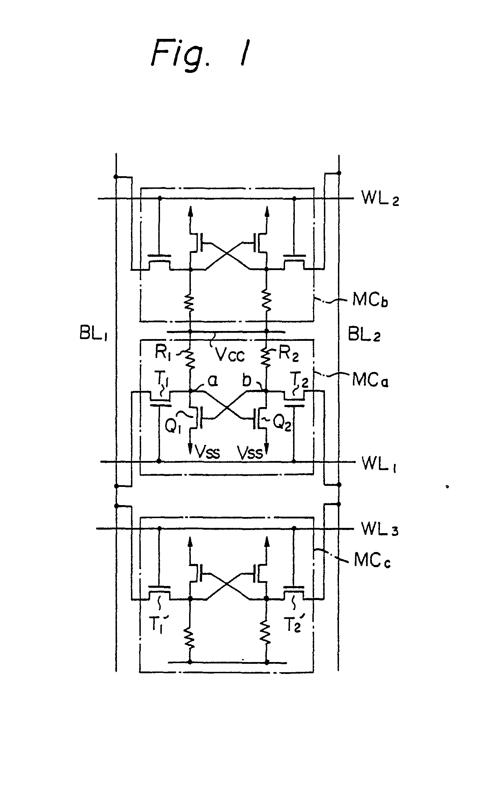

Fig. 1 schematically illustrates a part of a static RAM, in which $WL_1$, $WL_2$, ... denote word lines, $BL_1$ and $BL_2$ denote bit lines, and MCa, MCb, ...denote memory cells that are connected to intersecting points of the word lines and bit lines. Each memory cell consists of load resistors $R_1$, $R_2$, driving transistors $Q_1$, $Q_2$, and transistor $T_1$, $T_2$ for a transfer gate. Symbol $V_{cc}$ denotes a high potential level side of the power supply, and $V_{ss}$ denotes a low potential level side. The transistors $Q_1$ and $Q_2$ constitute a flip-flop circuit, together with the resistors $T_1$ and $R_2$, and one of them is always conductive and the other one is nonconductive. The load resistors $R_1$ and $R_2$ work to supply power to render the transistors conductive or nonconductive, and to maintain the transistors conductive. However, in order to reduce the power consumption by the memory, the load resistors should have a resistance as high as possible.

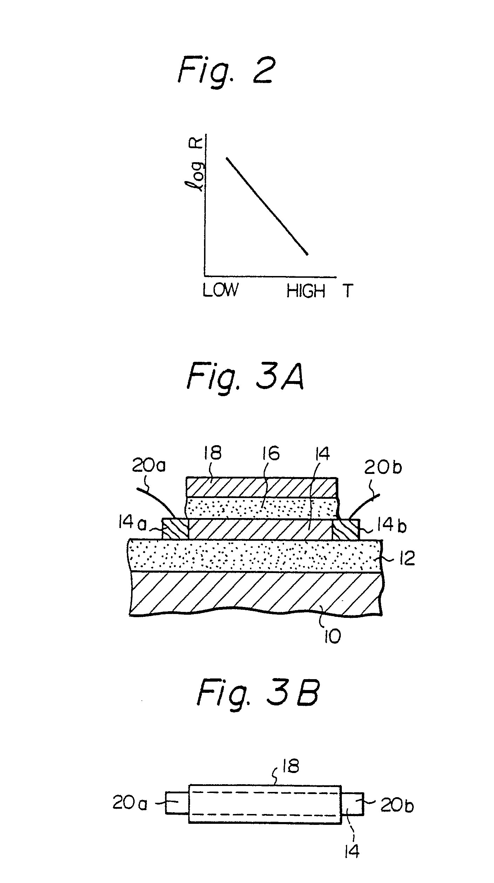

As already mentioned, a polycrystalline silicon film is suited as high-resistance load resistor for the memory cells, because the silicon film exhibits a greatly varying resistance depending upon the concentration of impurities, and a high resistance can be easily obtained if the concentration of impurities is decreased. However, the resistance of a polycrystalline silicon film changes greatly depending upon the temperature. In other words, referring to Figure 2 in which the ordinate represents logarithmic values log R and the abcissa represents the temperature T, the resistance of the polycrystalline silicon film decreases nearly linearly.

The object of the present invention is to avoid the already mentioned drawbacks resulting from the variation of the resistance of the semiconductor film with temperature. An embodiment of the invention is illustrated in Figures 3A and 3B. In Figure 3A, reference numeral 10 denotes a silicon semiconductor substrate, 12 denotes an insulating film composed of silicon dioxide ($SiO_2$) or the like, 14 denotes a polycrystalline silicon film that serves as a resistor, 14a and 14b denote electrodes to which lead wires 20a, 20b will be connected, 16 denotes a thin insulating film composed of silicon dioxide or the like, and 18 denotes a control electrode mounted on the thin insulating film. The control electrode 18 is composed of polycrystalline silicon, but may also be composed of aluminium or the like. Figure 3B is a plan view showing the shapes of the electrode 18, the polycrystalline silicon film 14 and the lead wires 20a, 20b. The polycrystalline silicon film 14 is formed through the ordinary steps used for forming transistors. That is, silicon is vaporized onto the insulating film 12 by the CVD method followed by patterning to obtain a desired shape, and impurities are implanted to a desired concentration, in order to form the polycrystalline silicon film 14. As required, in this case, the concentration of impurities is increased in the portion of the electrodes 14a, 14b. In the silicon film 14, the electrode portions serve as a source and a drain, respectively, and the portion therebetween serves as a channel, thereby forming an element such as a MOS transistor with the electrode 18 serving as gate electrode. When the silicon film 14 is of the n-type, if a negative voltage is applied to the gate electrode 18, a depletion layer is formed in the channel portion and the resistance is increased. If the voltage is increased with the rise in temperature, the reduction of resistance of the silicon film that is caused by the rise in temperature is offset, whereby the resistance vs. temperature coefficient is decreased.

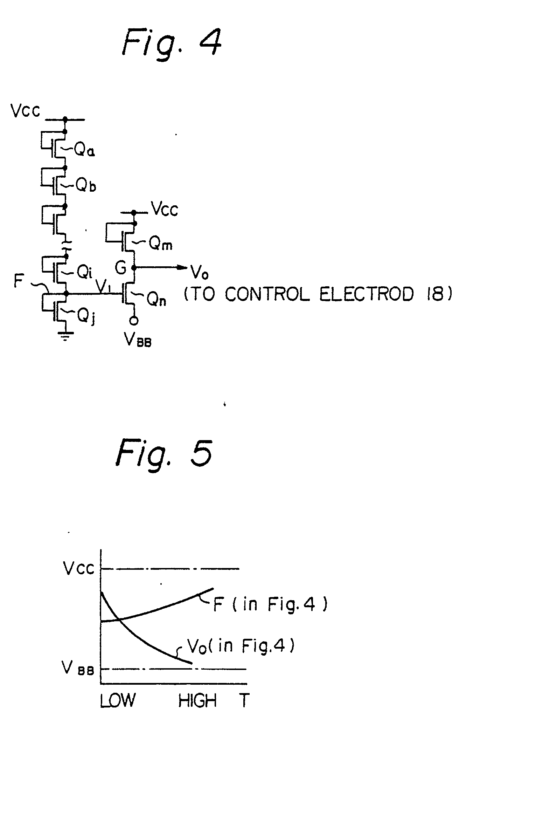

Figure 4 illustrates a circuit which generates a voltage that will be applied to the control electrode 18. In Figure 4, $Q_a$ through $Q_j$ denote MOS transistors that are connected in series between the power supply $V_{cc}$ and the ground; the drain and gate of each of the transistors are short-circuited, so that the transistors work as resistors. The transistors $Q_a$ through $Q_i$ have the same mutual conductance, but the transistor $Q_j$ has a small mutual conductance and works as a leakage resistor. Symbols $Q_m$ and $Q_n$ denote MOS transistors that are connected in series between the positive power supply $V_{cc}$ and the negative power supply $V_{BB}$, and that form an output stage of the circuit of Figure 4. The transistor $Q_m$ serves as a resistor with its drain and gate being short-circuited, and the transistor $Q_n$ receives the control voltage through the gate thereof, the control voltage being fed from an output terminal F of the transistor of the input stage. A connection point G between the transistor $Q_m$ and the transistor $Q_n$

serves as an output terminal of the circuit, and produces a voltage $V_0$ that will be applied to the control electrode 18. Here, the circuit of Figure 4 receives the same temperature as the semiconductor resistor element shown in Fiugres 3A and 3B.

The operation will be described below. The voltage $V_1$ at the point F becomes nearly equal to $V_{CC}$—i.Vth, where i denotes the number of transistors $Q_a$ through $Q_i$, and Vth denotes the threshold voltage of the transistors. Upon receipt of the voltage $V_1$, the transistor $Q_n$ assumes a given conductivity, and produces at the output terminal G a voltage $V_0$ that is obtained by dividing the coltage $V_{CC}$—$(-V_{BB})$. Figure 5 shows voltages at the points F and G of Figure 4. The threshold voltage Vth of the transistors $Q_a$ through $Q_i$ decreases with the increase in ambient temperature, whereby the voltage $V_1$ increases, the conductivity of the transistor $Q_n$ increases, and the output voltage $V_0$ increases toward the negative side. The number of transistors $Q_a$ through $Q_i$ and the threshold voltage Vth are suitably adjusted, such that the voltage $V_0$ will offset the change in resistance of the semiconductor film 14 that is caused by the change in temperature.

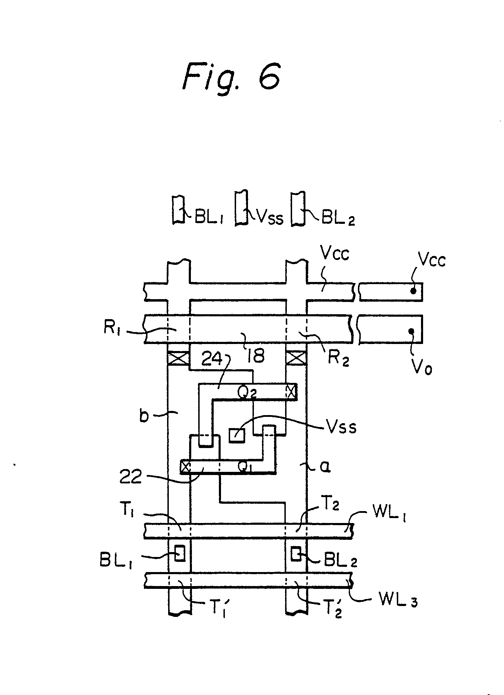

Figure 6 illustrates an example in which the above semiconductor element is incorporated in a memory cell. In Figure 6, the same reference numerals as those of Figure 1 represent the same members as those of Figure 1, and reference numerals 22, 24 denote gate electrodes of the transistors $Q_1$, $Q_2$. The drain region and the source region (denoted by a, b, $V_{ss}$) of the transistors $Q_1$, $Q_2$ extend on both sides of the gate electrodes 22, 24. The source and drain regions serve as so-called active regions surrounded by a field region on which is formed a thick insulating film. Reference numeral 18 denotes a wiring pattern for the control electrode. The wiring pattern is connected to the output terminal $V_0$ of Figure 5. Symbol x denotes the contacting portion.

According to the present invention as illustrated in the foregoing, it is possible to obtain a resistor which has a high resistance and a small resistance vs. temperature coefficient, and which is suited for use as a load resistor for static memory cells. The resistor of the present invention can be effectively used for LSI's. As an alternative to polycrystalline silicon, the semiconductor film may be composed of germanium (Ge) or gallium arsenide (GaAs). Further, when the resistor is to be used for a memory, the circuit of Figure 4 may, of course, be formed in a portion of the chip on which are formed the memory cells, such that the circuit receives the same temperature.

## Claims

1. A semiconductor device including a semiconductor resistor element $(R_1, R_2)$ in a circuit connected between a high potential level terminal $(V_{cc})$ and a low potential level terminal $(V_{ss})$, said resistor element comprising a semiconductor film (14) formed in a desired shape on a substrate, wirings (20a, 20b) formed at both ends of the semiconductor film and an electrode (18) provided on the semiconductor film between said two ends via an insulating film (16), said semiconductor device being characterized in that it further includes a control voltage generating circuit having:

—temperature detecting means which comprises a plurality of MOS transistors $(Q_a, Q_b, ... Q_i)$ the respective drains and gates of which are short-circuited, each transistor having nearly the same mutual conductance and a threshold voltage varying with temperature and being serially connected between said high potential level terminal $(V_{cc})$ being positive and an output terminal (F) of the temperature detecting means, and a further short-circuited MOS transistor $(Q_j)$ working as a leakage resistor connected between said output terminal and ground and having a small mutual conductance so as to generate on said output terminal an output voltage $(V_1)$ varying in accordance with the temperature; and

—an output stage comprising two MOS transistors $(Q_m, Q_n)$ connected in series between said high potential level terminal $(V_{cc})$ and a negative potential level terminal $(V_{BB})$, the first transistor $(Q_m)$ serving as a resistor with its drain and gate being short-circuited and the second transistor $(Q_n)$ receiving the output voltage $(V_1)$ of the temperature detecting means through the gate thereof and having a conductivity which varies in accordance with said output voltage to cause said output stage to generate a control voltage $(V_0)$ at the connection point (G) of both transistors $(Q_m, Q_n)$, said control voltage varying between the voltage at said negative and high potential level terminals as a function of the output voltage $(V_1)$ of the temperature detecting means;

—said control voltage $(V_0)$ being applied to said electrode (18) of the semiconductor resistor element to compensate for variations of the resistance of the semiconductor film with temperature.

2. A semiconductor device according to claim 1, characterized in that the semiconductor film (14) is composed of a polycristalline silicon film.

## Patentansprüche

1. Halbleitervorrichtung mit einem Halbleiterwiderstandselement $(R_1, R_2)$ in einer Schaltung, die zwischen einem Hochpotentialpegel-Anschluß $(V_{cc})$ und einem Niedrigpotentialpegel-Anschluß $(V_{ss})$ verbunden ist, welches genannte Widerstandselement einen Halbleiterfilm (14), der in einer gewünschten Form auf einem Substrat gebildet ist, Verdrahtungen (20a, 20b), die an beiden Enden des Halbleiterfilms gebildet sind, und eine Elektrode (18), die auf dem Halbleiterfilm zwischen den genannten beiden Enden über einem isolierenden Film (16) vorgesehen ist, umfaßt, welche Halbleitervorrichtung dadurch gekennzeichnet ist, daß sie ferner einen Steuerspannungs-Generatorschaltung enthält, die umfaßt:

—Temperaturfühleinrichtungen, die eine Viel-zahl von MOS-Transistoren ($Q_a$, $Q_b$, ... $Q_l$) umfaßt, deren entsprechende Drains und Gates kurzgeschlossen sind, wobei jeder Transistor etwa dieselbe wechselseitige Konduktanz und eine Schwellenwertspannung hat, die mit der Temperatur variiert, und seriell zwischen dem gennannten Hochpotentialpege-Anschluß ($V_{cc}$), der positive ist, und einem Ausgangsanschluß (F) der Temperaturfühleinrichtung angeschlossen ist, und einen weiteren kurzgeschlossenen MOS-Transistor ($Q_j$), der als ein Leckwiderstand arbeitet, der zwischen dem genannten Ausgangsanschluß und Erde verbunden ist und eine kleine wechselseitige Konduktanz hat, um so an dem genannten Ausgangsanschluß eine Ausgangs-spannung ($V_1$) zu erzeugen, die in Übereinstimmung mit der Temperatur variiert, und

—eine Ausgangsstufe, die zwei MOS-Transisto-ren ($Q_m$, $Q_n$), die in Reihe zwischen dem genannten Hochpotentialpegel-Anschluß ($V_{cc}$) und einem negativen Potentialpegel-Anschluß ($V_{BB}$) verbunden sind, wobei der erste Transistor ($Q_m$) dessen Drain un Gate kurzgeschlossen sind, als ein Widerstand dient, und der zweite Transistor ($Q_n$) die Ausgangsspannung ($V_1$) der Temperaturfüh-leinrichtung über sein Gate empfängt und eine Leitfähigkeit hat, die in Übereinstimung mit der genannten Ausgangsspannung variiert, um zu bewirken, daß die genannten Ausgangsstufe eine Steuerspannung ($V_0$) an dem Verbindungspunkt (G) beider Transistoren ($Q_m$, $Q_n$) erzeugt, welche genannte Steuerspannung zwischen der Spannung an dem genannten negativen und Hochpotentialpegel-Anschlüssen variiert, als eine Funk-tion der Ausgangsspannung ($V_1$) der Temperatur-fühleinrichtung;

—welche genannte Steuerspannung ($V_0$) der genannten Elektrode (18) des Halbleiterwiderstandselements zugeführt wird, um Variationen des Widerstands des Halbleiterfilms mit der Temperatur zu kompensieren.

2. Halbeitervorrichtung nach Anspruch 1, dadurch gekennzeichnet, daß der Halbleiterfilm (14) aus polykristallinem Siliziumfilm besteht.

**Revendications**

1. Dispositif à semiconducteurs comportant un élément de résistance semiconducteur ($R_1$, $R_2$) disposé dans un circuit qui est connecté entre une borne à niveau élevé de potentiel ($V_{cc}$) et une borne à niveau bas de potentiel ($V_{ss}$), ledit élé-ment de résistance comprenant une pellicule semiconductrice (14) réalisée sur un substrat suivant une forme voulue, des câblages (20a, 20b) formés au niveau des deux extrémités de la pellicule semiconductrice, et une électrode (18) disposée sur la pellicule semiconductrice entre lesdites deux extrémités par l'intermédiaire d'une pellicule isolante (16), ledit dispositif à semiconducteurs étant caractérisé en ce qu'il comporte en outre un circuit générateur de tension de commande possédant:

—un moyen de détection de température com-prenant plusieurs transistors MOS ($Q_a$, $Q_b$, ... $Q_l$) dont les drains et les grilles respectifs sont en court-circuit, les transistors ayant chacun approximativement la même conductance mutuelle et une tension de seuil qui varie avec la température et étant connectés en série entre ladite borne à niveau élevé de potentiel ($V_{cc}$), laquelle est positive, et une borne de sortie (F) du moyen de détection de température, et un autre transistor MOS en court-circuit ($Q_l$) faisant fonction d'une résistance de fuite connectée entre ladite borne de sortie et la terre et ayant une petite conductance mutelle de manière à produire sur ladite borne de sortie une tension de sortie ($V_1$) qui varie en fonction de la température; et

—un étage de sortie comprenant deux transis-tors MOS ($Q_m$, $Q_n$) connectés en série entre ladite borne à niveau de potentiel élevé ($V_{cc}$) et une borne à niveau de potentiel négatif ($V_{BB}$), le premier transistor ($Q_m$) faisant fonction de résis-tance, son drain et sa grille étant en court-circuit, et le deuxième transistor ($Q_n$) recevant la tension de sortie ($V_1$) du moyen de détection de température par l'intermédiare de sa grille et ayant une conductivité qui varie en fonction de ladite tension de sortie afin d'amener ledit étage de sortie à produire une tension de commande ($V_0$) au niveau du point de connexion (G) des deux transistors ($Q_m$, $Q_n$), ladite tension de commande variant entre la tension présente à ladite borne à niveau de potentiel négatif et ladite borne à niveau de potentiel élevé en fonction de la tension de sortie ($V_1$) du moyen de détection de température;

—ladite tension de commande ($V_0$) étant appli-quée à ladite électrode (18) de l'élément de résistance semiconducteur afin de compenser les variations de la valeur de résistance de la pellicule semiconductrice avec la température.

2. Dispositif à semiconducteurs selon la revendication 1, caractérisé en ce que la pellicule semiconductrice (14) est constituée d'une pelli-cule de silicium polycristallin.

# Fig. 1

# Fig. 2

# Fig. 3A

# Fig. 3B

# Fig. 4

Vcc

Qa
Qb

Vcc

Qm

F
Qi    G    Vo

V₁    (TO CONTROL ELECTROD 18)

Qn

Qj

V_BB

# Fig. 5

Vcc

F (in Fig. 4)

Vo (in Fig. 4)

V_BB

LOW        HIGH    T

Fig. 6